# EUROPÄISCHE PATENTSCHRIFT

(11) **EP 3 447 688 B1**
(45) Veröffentlichungstag und Bekanntmachung des Hinweises auf die Patenterteilung: **27.05.2020**
(21) Anmeldenummer: 18196937.9
(22) Anmeldetag: 12.07.2013
(51) Int. Cl.: G06K 19/077, H01L 23/00

(54) **TRANSPONDERLAGE UND VERFAHREN ZU DEREN HERSTELLUNG**
TRANSPONDER LAYER AND METHOD FOR PRODUCING SAME
COUCHE DE TRANSPONDEUR ET PROCÉDÉ POUR SA FABRICATION

(30) Priorität: 13.07.2012 DE 102012212332
(43) Veröffentlichungstag der Anmeldung: 27.02.2019
(62) Teilanmeldung aus: 13745342.9
(73) Patentinhaber: Linxens Holding S.A.S., 78200 Mantes-la-Jolie (FR)
(72) Erfinder: Häring, Martin, 82110 Germering (DE); Dorn, Stephan, 70176 Stuttgart (DE); Kriebel, Frank, 01896 Lichtenberg (DE); Nieland, Carsten, 99867 Gotha (DE)
(74) Vertreter: advotec.

(56) Entgegenhaltungen:
- WO-A1-2009/003299
- DE-A1-102007 022 615
- FR-A1- 2 828 570
- US-A1- 2011 204 147

## Beschreibung

Die vorliegende Erfindung betrifft eine Transponderlage, insbesondere zur Herstellung einer beispielsweise als Chipkarte ausgebildeten Laminatstruktur, mit den Merkmalen des Oberbegriffs deas Anspruchs 1.

Des Weiteren betrifft die vorliegende Erfindung ein Laminatinlay für eine aus mehreren Laminatlagen gebildete Laminatstruktur mit einer derartigen Transponderlage sowie eine Chipkarte mit einem derartigen Laminatinlay und ein Verfahren zur Herstellung einer derartigen Transponderlage.

Insbesondere bei der Herstellung von kontaktlosen Chipkarten ist es bekannt, zur Vereinfachung der Kontaktierung des Chips sowie zur Erzielung eines mechanischen Schutzes für den Chip, den Chip in einer Gehäusung auf einem Kontaktträger anzuordnen, wobei der Kontaktträger zusammen mit dem in der Gehäusung aufgenommenen Chip ein Chipmodul ausbildet. Das Chipmodul weist auf seiner durch den Kontaktträger ausgebildeten Kontaktoberfläche gegenüber den Anschlussflächen des Chips vergrößerte Modulkontaktflächen auf, die die Kontaktierung des Chips mit den Anschlussenden der Antenne vereinfachen.

Das Chipmodul weist im Vergleich zu den Abmessungen des Halbleiterkörpers des Chips wesentlich vergrößerte äußere Abmessungen auf. Insbesondere ist die Höhe des Chipmoduls wesentlich größer als die Höhe des eigentlichen Chips, so dass die Anordnung eines Chipmoduls in einer Laminatstruktur bereits eine entsprechende Anzahl von Laminatlagen voraussetzt. Bei bekannten, eine Laminatstruktur aufweisenden Karten ist es daher regelmäßig so, dass bereits eine Laminatlage für die Unterbringung des mit den vergrößerten Anschlussflächen versehenen Kontaktträges des Chipmoduls benötigt wird und eine zweite Laminatlage, um die den Halbleiterkörper des Chips umschließende Gehäusung in der Laminatstruktur unterzubringen.

Wenn man davon ausgeht, dass regelmäßig zur Abdeckung der Antenne des Antennensubstrats sowie zur Abdeckung des Chipmoduls jeweils mindestens eine weitere Laminatlage erforderlich wird, so ergibt sich bei den bekannten, als Laminatstruktur aufgebauten Chipkarten eine Mindestanzahl von vier Laminatlagen, die möglicherweise noch durch weitere äußere Laminatlagen ergänzt werden, welche als Sichtlagen maßgeblich für die äußere Gestaltung der Chipkarten sind.

Aus der DE 10 2007 022 615 A1 ist ein kontaktloses Übertragungssystem und Verfahren zum Herstellen desselben bekannt, bei dem ein Chip in einer Ausnehmung einer Transponderlage angeordnet ist, während Kontaktmetallisierungen zur Verbindung des Chips mit einem Antennen-30 draht auf der Oberfläche der Transponderlage angeordnet sind.

Die FR 2 828 570 zeigt eine Methode zur Herstellung von Smartcards, bei der zwischen ein Chipmodul einerseits und die Anschlusspads einer Antenne der Smartcard andererseits ein Isolator platziert wird, der bereichsweise leitende Oberflächen aufweist.

Der vorliegenden Erfindung liegt die Aufgabe zugrunde, die Herstellung einer Chipkarte mit einer möglichst geringen Anzahl von Laminatlagen zu ermöglichen, die zudem insgesamt schneller und günstiger hergestellt werden kann.

Zur Lösung dieser Aufgabe weist eine erfindungsgemäße Transponderlage die Merkmale des Anspruchs 1, ein erfindungsgemäßes Laminatinlay die Merkmale des Anspruchs 4, eine erfindungsgemäße Chipkarte die Merkmale des Anspruchs 8 und das erfindungsgemäße Verfahren die Merkmale des Anspruchs 11 auf.

Die erfindungsgemäße Transponderlage weist ein Antennensubstrat auf, das auf einer Antennenseite mit einer aus einem Drahtleiter gebildeten Antenne und einem Chip versehen ist, und das auf der Antennenseite Anschlussleiter zur Verbindung des Chips mit dem Drahtleiter der Antenne aufweist. Der Chip ist neben den Anschlussenden des Drahtleiters angeordnet, wobei sowohl die Anschlussenden des Drahtleiters als auch auf einer dem Antennensubstrat zugewandten Kontaktseite des Halbleiterkörpers des Chips angeordnete Chipanschlüsse mit den Anschlussleitern kontaktiert sind, wobei die Anschlussleiter zur Verbindung des Chips mit dem Drahtleiter der Antenne als Kontaktpads ausgebildet und derart auf der Antennenseite angeordnet sind, dass die Kontaktpads zur Kontaktierung mit der Antenne einen Antennenkontaktabschnitt mit einer der Antennenseite zugewandten Antennenkontaktseite und zur Kontaktierung mit dem Chip einen Chipkontaktabschnitt mit einer der Antennenkontaktseite gegenüberliegenden und von der Antennenseite abgewandten Chipkontaktseite aufweisen, wobei die Kontaktpads mit ihrer Chipkontaktseite auf einem Trägersubstrat angeordnet sind und zur Kontaktierung des Chips mit den Kontaktpads die Chipanschlüsse sich durch das Trägersubstrat hindurch erstrecken.

Die erfindungsgemäß ausgebildete Transponderlage ermöglicht die Anordnung des Chips unter Verzicht auf eine den Chip aufnehmende Gehäusung zusammen mit der Antenne auf ein und demselben Substrat, wobei der Chip und die Anschlussenden des Drahtleiters der Antenne im Wesentlichen in einer Ebene angeordnet werden können und die den Chip zwischen sich aufnehmenden Anschlussenden des Drahtleiters - bei entsprechenden mechanischen Eigenschaften des Drahtleiters - eine mechanisch stützende bzw. versteifende Struktur in der unmittelbaren Umgebung des Chips ausbilden, so dass der Chip nicht nur so auf der Antennenseite des Antennensubstrats angeordnet ist, dass er den Querschnitt der Anschlussenden nur unwesentlich überragt und somit eine besonders geringe Bauhöhe des Antennensubstrats bzw. der Transponderlage ermöglicht, sondern darüber hinaus der Chip auch geschützt zwischen den Anschlussenden des Drahtleiters aufgenommen ist.

Somit ist bei der erfindungsgemäßen Transponderlage trotz Verzichts auf ein den Halbleiterkörper des Chips aufnehmendes Gehäuse eines Chipmoduls der Halbleiterkörper des Chips insbesondere vor einer wechselnden Biegebeanspruchung, die beispielsweise im Gebrauch einer die Transponderlage aufweisenden Chipkarte auftritt, geschützt, bzw. werden entsprechende dynamische Belastungen zumindest teilweise von den den Chip zwischen sich aufnehmenden Anschlussenden des Drahtleiters aufgenommen.

Darüber hinaus ermöglicht die erfindungsgemäße Transponderlage durch die auf der Antennenseite angeordneten Anschlussleiter, die im Vergleich zu den Chipanschlüssen eine große Flächenerstreckung aufweisen können, eine sichere Kontaktierung zwischen dem Chip und den Anschlussenden des Drahtleiters, ohne dass der Chip, wie es bei einem Chipmodul der Fall ist, auf einem vom Antennensubstrat unabhängigen Kontaktsubstrat angeordnet werden müsste, um für die Kontaktierung mit den Anschlussenden der Antenne im Vergleich zu den Chipanschlüssen vergrößerte Anschlussflächen zur Verfügung zu stellen.

Die erfindungsgemäße Transponderlage ermöglicht trotz Verzichts auf ein Chipmodul die sichere Kontaktierung zwischen dem Chip und der Antenne, dadurch, dass auf dem Antennensubstrat Anschlussleiter zur Verfügung gestellt werden, die sowohl eine Verbindung mit den Anschlussenden der Antenne als auch eine Verbindung mit den Chipanschlüssen des Chips ermöglichen.

Bei einer bevorzugten Ausführungsform ist der Chip zwischen den Anschlussenden des Drahtleiters angeordnet, so dass eine möglichst kompakte Unterbringung des Chips mit einer beidseitigen Anordnung der Anschlussenden des Drahtleiters ermöglicht wird.

Erfindungsgemäß sind die Anschlussleiter zur Verbindung des Chips mit dem Drahtleiter der Antenne als Kontaktpads ausgebildet und derart auf der Antennenseite angeordnet, dass die Kontaktpads zur Kontaktierung mit der Antenne einen Antennenkontaktabschnitt mit einer der Antennenseite zugewandten Antennenkontaktseite und zur Kontaktierung mit dem Chip einen Chipkontaktabschnitt mit einer der Antennenkontaktseite gegenüberliegenden und von der Antennenseite abgewandten Chipkontaktseite aufweisen.

Bei dieser Ausführungsform sind die auf der Antennenseite des Antennensubstrats angeordneten Anschlussleiter aufgrund der an einander gegenüberliegenden Seiten der Anschlussleiter, nämlich der Antennenkontaktseite und der Chipkontaktseite, erfolgten Kontaktierung mit den Anschlussenden der Antenne und den Chipanschlüssen zwischen den Chipanschlüssen und den Anschlussenden angeordnet. Damit kann die Herstellung einer Transponderlage ausgehend von einem Antennensubstrat erfolgen, das lediglich einen zur Ausbildung der Antenne auf dem Antennensubstrat angeordneten bzw. verlegten Drahtleiter aufweist.

Ein besonders guter und großflächiger Kontakt zwischen den Kontaktpads und den Anschlussenden des Drahtleiters der Antenne wird möglich, wenn die Kontaktpads zur Kontaktierung mit der Antenne mit ihrer Antennenkontaktseite an die Querschnittskontur des Drahtleiters angeschmiegt ausgebildet sind.

Erfindungsgemäß sind die Kontaktpads mit ihrer Chipkontaktseite auf einem Trägersubstrat angeordnet und zur Kontaktierung des Chips mit den Kontaktpads erstrecken sich die Chipanschlüsse durch das Trägersubstrat hindurch. , Die Kontaktpads können so durch die Anordnung auf einem gemeinsamen Trägersubstrat einfach gehandhabt und positionsgenau platziert werden. Eine besonders einfache Applikation der als Kontaktpads ausgebildeten Anschlussleiter auf der Antennenseite des Antennensubstrats mit gleichzeitiger Anordnung der Antennenkontaktseiten auf den Anschlussenden des Drahtleiters wird so möglich.

Bei dem erfindungsgemäßen Laminatinlay für eine aus mehreren Laminatlagen gebildete Laminatstruktur ist die Transponderlage auf ihrer Antennenseite mit einer oberen Decklage versehen, die in einem Überdeckungsbereich mit dem Chip auf einer Rückseite des Halbleiterkörpers des Chips angeordnet ist.

Hierdurch wird ein Laminatinlay vorgeschlagen, das insbesondere als Halbzeug bei der Herstellung von Chipkarten verwendbar ist und welches bereits die geschützte Anordnung sowohl der Antenne als auch des Chips in einer Laminatstruktur mit lediglich zwei Laminatlagen ermöglicht.

Wenn die obere Decklage sowohl auf der Rückseite des Halbleiterkörpers des Chips als auch auf den Kontaktpads angeordnet ist, ergibt sich eine den Chip in besonderer Weise stabilisierende Umhüllung durch die obere Decklage.

Eine stabilisierende Wirkung für das gesamte Laminatinlay lässt sich erzielen, wenn die obere Decklage sowohl auf der Rückseite des Halbleiterkörpers des Chips als auch auf dem Trägersubstrat der Kontaktpads angeordnet ist.

Alternativ kann, insbesondere dann, wenn auf die Verwendung eines Trägersubstrats für die Kontaktpads verzichtet wird, die obere Decklage sowohl auf der Rückseite des Halbleiterkörpers des Chips als auch auf den Anschlussenden des Drahtleiters der Antenne angeordnet sein, um eine vergleichbar stabilisierende Wirkung zu erzielen.

Die erfindungsgemäße Chipkarte weist die Merkmale des Anspruchs 11 auf. Diese ist in einer Minimalkonfiguration bereits durch das Laminatinlay selbst ausgebildet.

In einer besonderen Ausführungsform kann die Chipkarte ergänzend eine unmittelbar auf der oberen Decklage des Laminatinlays angeordnete obere Außenlage aufweisen, die als Funktionslage oder auch als Laminatlage mit besonderer, insbesondere individualisierender, Kennzeichnung der Chipkarte ausgebildet sein kann.

Alternativ zu der mit einer oberen Außenlage versehenen Chipkarte kann die Chipkarte in einer weiteren Ausführungsform auf der Rückseite des Antennensubstrats mit einer unteren Außenlage versehen sein, wobei diese untere Außenlage auch ergänzend zu der oberen Außenlage auf dem Laminatinlay der Chipkarte angeordnet sein kann.

Selbst dann, wenn gemäß einer Ausführungsform der Chipkarte neben der oberen Außenlage eine untere Außenlage vorgesehen ist, zeichnet sich auch eine derartig individuell ausgestaltete Chipkarte immer noch durch eine Laminatstruktur mit einer möglichst geringen Anzahl von Laminatlagen aus.

Bei dem erfindungsgemäßen Verfahren zur Herstellung einer Transponderlage erfolgt eine
- Bereitstellung eines Antennensubstrats mit einer auf einer Antennenseite des Antennensubstrats angeordneten, aus einem Drahtleiter gebildeten Antenne mit Anschlussenden des Drahtleiters, die sich mit Abstand voneinander auf der Antennenseite des Antennensubstrats erstrecken,
- Anordnung von Kontaktpads auf den Anschlussenden des Drahtleiters, derart, dass sich die Kontaktpads jeweils mit einem Antennenkontaktabschnitt auf einem Anschlussende und mit einem Chipkontaktabschnitt auf der Antennenseite des Antennensubstrats erstrecken,
- Kontaktierung der Antennenkontaktabschnitte der Kontaktpads mit den Anschlussenden des Drahtleiters,
- Anordnung des Chips in einem neben den Anschlussenden gebildeten Chipaufnahmebereich des Antennensubstrats, derart, dass auf einer Kontaktseite des Halbleiterkörpers des Chips angeordnete Chipanschlüsse jeweils auf einem Chipkontaktabschnitt der Kontaktpads angeordnet sind, sowie eine
- Kontaktierung der Chipanschlüsse mit den Chipkontaktabschnitten der Kontaktpads,
wobei ein mit den Kontaktpads versehenes Trägersubstrat derart auf der Antennenseite des Antennensubstrats positioniert wird, dass die Antennenkontaktabschnitte der Kontaktpads mit ihrer dem Antennensubstrat zugewandten Antennenkontaktseite zur Anlage gegen die Anschlussenden des Drahtleiters kommen.

Die Kontaktierung der Kontaktpads mit den Anschlussenden des Drahtleiters kann grundsätzlich auf alle bekannten Arten und Weisen erfolgen, wobei sich zur Ausführung der Kontaktierung eine rückwärtige Beaufschlagung der Kontaktpads mit Wärme und/oder Druck besonders bewährt hat, da diese Art der Kontaktierung es bei entsprechender Materialauswahl für die Kontaktpads ermöglicht, die Kontaktierung ohne Zuführung zusätzlichen Kontaktmaterials und lediglich durch zumindest oberflächliches Aufschmelzen der Kontaktpads durchzuführen.

Besonders vorteilhaft ist die rückwärtige Beaufschlagung der Kontaktpads mittels eines Ultraschallstempels, so dass das Ultraschallwerkzeug neben der Einleitung der notwendigen Kontaktierungsenergie auch eine genaue Kontaktpositionierung der Kontaktpads auf den Anschlussenden des Drahtleiters ermöglicht.

Nachfolgend werden anhand der Zeichnung vorteilhafte Ausführungsformen der Transponderlage und der bei der Herstellung einer Transponderlage zum Einsatz kommenden Verfahren erläutert.

Es zeigen:
- **Fig. 1**: eine erste Ausführungsform einer Transponderlage in Draufsicht;
- **Fig. 2**: eine Schnittdarstellung der in **Fig. 1** dargestellten Transponderlage gemäß Schnittlinienverlauf II-II in **Fig.1****;**
- **Fig. 3**: eine Schnittdarstellung einer weiteren Ausführungsform der Transponderlage;
- **Fig. 4-7**: eine Abfolge verschiedener Verfahrensschritte zur Herstellung der in den **Fig. 1 und 2** dargestellten Transponderlage;
- **Fig. 8-11**: eine Abfolge der Herstellungsschritte zur Herstellung der in **Fig. 3** im Schnitt dargestellten Transponderlage;
- **Fig. 12**: ein auf Basis der in **Fig. 11** dargestellten Transponderlage hergestelltes Laminatinlay;
- **Fig. 13**: eine von der Erfindung abweichende weitere Ausführungsform einer Transponderlage in einer Draufsicht;
- **Fig. 14-18**: eine Abfolge von Verfahrensschritten zur Herstellung der in **Fig. 13** dargestellten Transponderlage;
- **Fig. 19-22**: eine Abfolge von Verfahrensschritten zur Herstellung einer weiteren Ausführungsform einer Transponderlage.

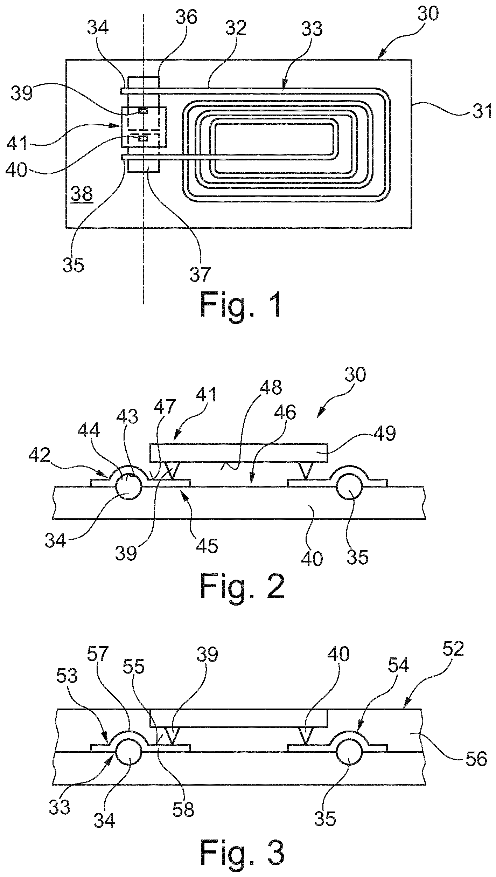

**Fig. 1** zeigt eine Transponderlage 30 mit einem Antennensubstrat 31, auf dem eine aus einem Drahtleiter 32 gebildete Antenne 33 angeordnet ist. Die Antenne 33 ist über Anschlussenden 34, 35 des Drahtleiters 32 jeweils mit einem als Kontaktpad 36, 37 ausgebildeten Anschlussleiter kontaktiert, der sich auf einer Antennenseite 38 des Antennensubstrats 31 erstreckt und gleichzeitig zur Kontaktierung mit Chipanschlüssen 39, 40 eines Chips 41 dient.

Wie aus der Schnittdarstellung gemäß **Fig. 2** hervorgeht, erstrecken sich die Kontaktpads 36, 37 mit einem Antennenkontaktabschnitt 42 über die Anschlussenden 34, 35 des Drahtleiters 32, wobei jeweils eine Antennenkontaktseite 43 der Kontaktpads 36, 37 an einen Querschnitt 44 des Drahtleiters 32 angeschmiegt anliegt. Anschließend an den Antennenkontaktabschnitt 42 weisen die Kontaktpads 36, 37 jeweils einen Chipkontaktabschnitt 45 auf, der sich in einen Chipaufnahmebereich 46 hinein erstreckt, der zwischen den Anschlussenden 34, 35 auf der Antennenseite 38 des Antennensubstrats 31 ausgebildet ist.

Im Bereich der Chipkontaktabschnitte 45 sind die Kontaktpads 36, 37 auf ihrer der Antennenkontaktseite 43 gegenüberliegenden Chipkontaktseite 47 jeweils mit einem auf einer Kontaktseite 48 eines Halbleiterkörpers 49 des Chips 41 angeordneten Chipanschluss 39, 40 kontaktiert.

In der in **Fig. 2** beispielhaft dargestellten Kontaktierung zwischen den Chipanschlüssen 39, 40 des Chips 41 und den Kontaktpads 36, 37 erfolgt die Ausbildung einer elektrisch leitenden Verbindung dadurch, dass die im Ausführungsbeispiel als profilierte, etwa keil- oder kegelförmige Eindringkörper ausgebildeten Chipanschlüsse 39, 40 in den Chipkontaktabschnitt 45 eingepresst werden, so dass nicht nur eine formschlüssige Verbindung zwischen den Chipanschlüssen 39, 40 und den Chipkontaktabschnitten 45 der Kontaktpads 36, 37 hergestellt wird, sondern gleichzeitig bei der Herstellung der Verbindung bzw. während des Eindringens der Chipanschlüsse 39, 40 in die Kontaktpads 36, 37 etwaige Oxydschichten auf der Chipkontaktseite 47 der Kontaktpads 36, 37 aufgebrochen werden.

Eine Fixierung der Verbindung zwischen den Chipanschlüssen 39, 40 und den Kontaktpads 36, 37 kann beispielsweise durch nachträgliches zumindest partielles Aufschmelzen der Chipanschlüsse 39, 40 und/oder der Kontaktpads 36, 37 erfolgen. Mittels des vorgenannten partiellen Aufschmelzens kann auch die elektrisch leitende Verbindung zwischen den Antennenkontaktabschnitten 42 der Kontaktpads 36, 37 und den Anschlussenden 34, 35 des die Antenne 33 bildenden Drahtleiters 32 erfolgen.

**Fig. 3** zeigt in einer **Fig. 2** entsprechenden Darstellung eine Transponderlage 52, die sich insoweit von der in **Fig. 2** dargestellten Transponderlage 30 unterscheidet, als zur Kontaktierung mit den Anschlussenden 34, 35 des die Antenne 33 bildenden Drahtleiters 32 mit den Chipanschlüssen 39, 40 des Chips 41 Kontaktpads 53, 54 dienen, die mit ihrer Chipkontaktseite 55 auf einem Trägersubstrat 56 angeordnet sind. Im Übrigen sind die Kontaktpads 53, 54 in Übereinstimmung mit den Kontaktpads 36, 37 der in **Fig. 2** dargestellten Transponderlage 30 im Bereich ihres Antennenkontaktabschnitts 57 mit den Anschlussenden 34, 35 des Drahtleiters 32 kontaktiert und im Bereich ihres an den Antennenkontaktabschnitt 57 anschließenden Chipkontaktabschnitts 58 mit den Chipanschlüssen 39, 40 des Chips 41 kontaktiert.

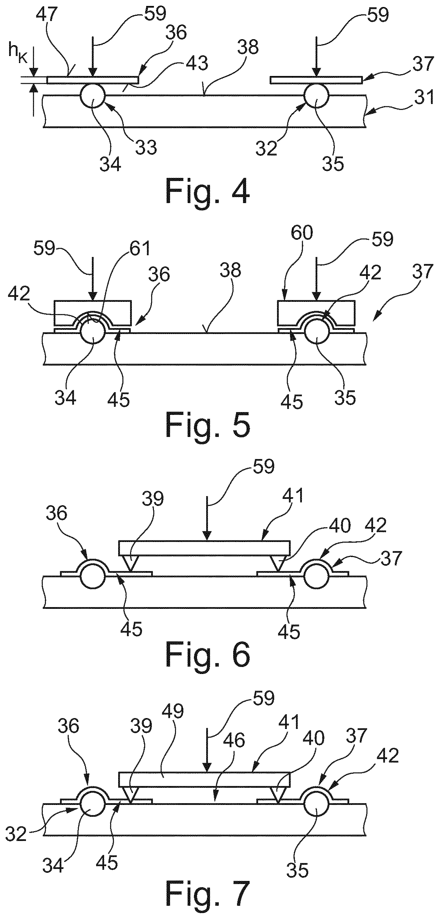

Wie sich aus der in den **Fig. 4 bis 7** dargestellten Abfolge der Verfahrensschritte zur Herstellung der in **Fig. 2** dargestellten Transponderlage 30 ergibt, erfolgt bei der dargestellten Verfahrensvariante ausgehend von der Bereitstellung des Antennensubstrats 31 mit der auf der Antennenseite 38 des Antennensubstrats 31 bereits angeordneten, aus dem Drahtleiter 32 gebildeten Antenne 33 zunächst die Anordnung der Kontaktpads 36, 37, die eine im Wesentlichen flächige Erstreckung aufweisen mit einer relativ geringen Höhe h_{K} im Vergleich zu der Fläche der den Anschlussenden 34, 35 des Drahtleiters 32 zugewandten Antennenkontaktseite 43 bzw. der der Antennenkontaktseite 43 gegenüberliegenden Chipkontaktseite 47. Nach Zuführung der Kontaktpads 36, 37 gegen die Anschlussenden 34, 35 in Zuführrichtung 59 erfolgt, wie in Fig. 5 dargestellt, eine Umformung der Kontaktpads 36, 37 mittels eines Umformwerkzeugs 60, das in Zuführrichtung 59 gegen die Kontaktpads 36, 37 bewegt wird und dabei aufgrund einer im Umformwerkzeug 60 ausgebildeten Ausformung 61 eine Anschmiegung der Kontaktpads 36, 37 im Bereich ihrer Antennenkontaktabschnitte 42 an die Anschlussenden 34, 35 des Drahtleiters 32 bewirkt.

Wenn gleichzeitig mit der Beaufschlagung der Kontaktpads 36, 37 durch das Umformwerkzeug 60 eine Beheizung des Umformwerkzeugs 60 erfolgt, kann bei geeigneter Materialauswahl für die Kontaktpads 36, 37 bzw. bei einer geeigneten Beschichtung der Antennenkontaktseite 43 der Kontaktpads 36, 37 eine stoffschlüssige Verbindung zwischen den Kontaktpads 36, 37 und den Anschlussenden 34, 35 hergestellt werden.

**Fig. 6** zeigt die Applikation des Chips 41 in Zuführrichtung 59 im Chipaufnahmebereich 46 zwischen den Anschlussenden 34, 35 des Drahtleiters 32, derart, dass die Chipanschlüsse 39, 40 des Chips 41 zur Anlage gegen die Chipkontaktabschnitte 45 der Kontaktpads 36, 37 gebracht werden. Anschließend kann bewirkt durch eine rückwärtige Beaufschlagung des Halbleiterkörpers 49 des Chips 41 mit Druck und Wärmeenergie ein Eindringen der Chipanschlüsse 39, 40 in die Chipkontaktabschnitte 45 der Kontaktpads 36, 37 mit gleichzeitigem partiellen Aufschmelzen der Chipanschlüsse 39, 40 und/oder der Chipkontaktabschnitte 45 der Kontaktpads 36, 37 zur Herstellung einer stoffschlüssigen Verbindung zwischen den Chipanschlüssen 39, 40 und den Kontaktpads 36, 37 erfolgen.

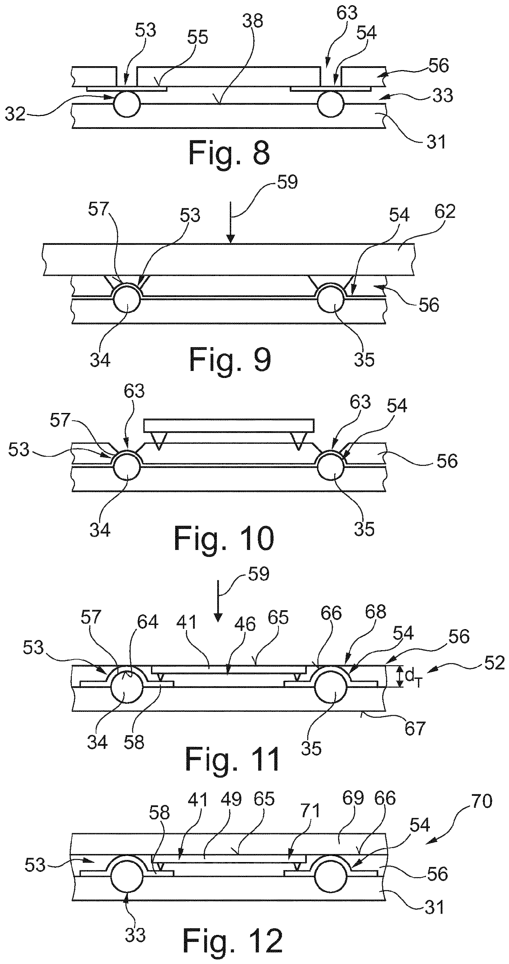

In den **Fig. 8 bis 11** ist eine mögliche Variante eines Verfahrens zur Herstellung der in **Fig. 3** dargestellten Transponderlage 52 dargestellt, wobei auch hier ausgehend von einer bereits auf der Antennenseite 38 des Antennensubstrats 31 angeordneten Antenne 33 eine Applikation der Kontaktpads 53, 54, die mit ihrer Chipkontaktseite 55 auf dem Trägersubstrat 56 angeordnet sind, erfolgt. Aufgrund der Anordnung der Kontaktpads 53, 54 auf dem Trägersubstrat 56 können diese beispielsweise aus einer elektrisch leitenden Beschichtung des Trägersubstrats 56, also beispielsweise durch eine in Drucktechnik aufgebrachte Beschichtung, gebildet sein.

Wie **Fig. 9** zeigt, kann eine angeschmiegte Anordnung des Antennenkontaktabschnitts 57 der Kontaktpads 53, 54 auf den Anschlussenden 34, 35 dadurch erreicht werden, dass eine rückwärtige Druckbeaufschlagung des Trägersubstrats 56 mittels einer Druckplatte 62 in Zuführrichtung 59 erfolgt.

Wie in den **Fig. 8 bis 10** zu erkennen ist, ist im Falle des dargestellten Ausführungsbeispiels das Trägersubstrat 56 im Bereich der Antennenkontaktabschnitte 57 der Kontaktpads 53, 54 mit Ausnehmungen 63 versehen, die nach Ausbildung der Anschmiegung der Antennenkontaktabschnitte 57 an die Anschlussenden 34, 35 eine rückwärtige Beaufschlagung der Kontaktpads 53, 54 mit Wärmeenergie ermöglichen, um bei entsprechender Materialwahl für die Kontaktpads 53, 54 bzw. geeigneter Beschichtung von Antennenkontaktseiten 64 der Kontaktpads 53, 54 durch ein partielles Aufschmelzen eine stoffschlüssige Verbindung zwischen den Kontaktpads 53, 54 und den Anschlussenden 34, 35 zu ermöglichen.

Wie **Fig. 10** zeigt, kann nachfolgend der Chip 41 in dem Chipaufnahmebereich 46 zwischen den Anschlussenden 34, 35 platziert werden, wobei die Chipanschlüsse 39, 40 des Chips 41 in das Trägersubstrat 56 eindringen und schließlich, wie in **Fig. 11** dargestellt, bei fortwährender Druckbeaufschlagung des Halbleiterkörpers 49 des Chips 41 in Zuführrichtung 59 in Chipkontaktabschnitte 58 eindringen und, wie bereits anhand der **Fig. 7** betreffend die Transponderlage 30 erläutert, mit den Kontaktpads 53, 54 stoffschlüssig verbunden werden können.

Wie aus der Figurenabfolge der **Fig. 10 und 11** ersichtlich, kann bei geeigneter Dimensionierung bzw. geeigneter Dicke d_{T} und Auswahl des Kunststoffmaterials des Trägersubstrats 56 gleichzeitig mit der Kontaktierung des Chips 41 mit den Kontaktpads 53, 54 eine Einbettung des Chips 41 in das Trägersubstrat 56 erfolgen, so dass, wie in **Fig. 11** dargestellt, nach erfolgter Kontaktierung des Chips 41 mit den Kontaktpads 53, 54 der Halbleiterkörper 49 des Chips 41 mit seiner Rückseite 65 im Wesentlichen bündig in einer Rückseite 66 des Trägersubstrats 56 aufgenommen ist, so dass die Transponderlage 52 eine zu einer Unterseite 67 des Antennensubstrats 31 parallel und eben ausgebildete Transponderoberseite 68 aufweist.

**Fig. 12** zeigt, dass basierend auf der in **Fig. 11** dargestellten Transponderlage 52 durch einfaches Hinzufügen einer oberen Decklage 69 auf die Transponderoberseite 68 ein Laminatinlay 70 gebildet werden kann, das einen in einer das Antennensubstrat 31, das Trägersubstrat 56 und die Decklage 69 umfassenden Laminatstruktur aufgenommenen und nach außen hermetisch abgedichteten Transponder 71 aufweist, mit einem über die Kontaktpads 53, 54 mit der Antenne 33 kontaktierten Chip 41.

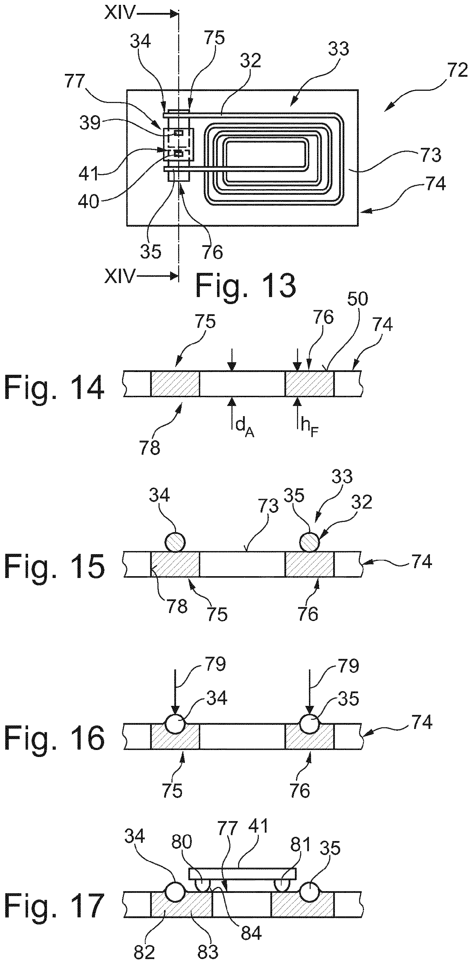

**Fig. 13** zeigt eine Transponderlage 72, mit einer auf einer Antennenseite 73 eines Antennensubstrats 74 angeordneten und aus einem Drahtleiter 32 gebildeten Antenne 33, die über Anschlussenden 34, 35 des Drahtleiters 32 mit Kontaktpads 75, 76 elektrisch leitend verbunden ist. Die Kontaktpads 75, 76 sind im Antennensubstrat 74 angeordnet und erstrecken sich in einem zwischen den Anschlussenden 34, 35 des Drahtleiters 32 auf der Antennenseite 73 ausgebildeten Chipaufnahmebereich 77, der im Chip 41 angeordnet und über Chipanschlüsse 39, 40 mit den Kontaktpads 75, 76 elektrisch leitend verbunden ist.

In den **Fig. 14 bis 18** ist gemäß einer möglichen Variante die Abfolge von Verfahrensschritten zur Herstellung der in **Fig. 13** dargestellten Transponderlage 72 dargestellt.

Wie **Fig. 14****,** in der das Antennensubstrat 74 in einer Schnittdarstellung gemäß Schnittlinienverlauf XIV-XIV dargestellt ist, zeigt, ist bei der dargestellten Verfahrensvariante Ausgangsbasis das Antennensubstrat 74, welches in Substratausnehmungen 78 mit den Kontaktpads 75, 76 versehen ist, die als Füllkörper die Substratausnehmungen 78 ausfüllen. Die Kontaktpads 75, 76 stimmen daher in ihrer Höhe hp im Wesentlichen mit der Dicke d_{A} des Antennensubstrats 74 überein, so dass Kontaktseiten 50 der Kontaktpads 75, 76 im Wesentlichen an der Oberfläche der Antennenkontaktseite 73 des Antennensubstrats 74 angeordnet sind.

Nachfolgend kann die Antenne 33 durch Anordnung bzw. Verlegung des Drahtleiters 32 auf der Antennenseite 73 des Antennensubstrats 74 ausgebildet werden, derart, dass die Anschlussenden 34, 35 des Drahtleiters 32 sich über die in den Substratausnehmungen 78 des Antennensubstrats 74 aufgenommenen Kontaktpads 75, 76 erstrecken, wie in **Fig. 15** dargestellt.

Durch eine Beaufschlagung 79 der Anschlussenden 34, 35 mit Druck und Wärmeenergie kann eine stoffschlüssige Verbindung zwischen den Anschlussenden 34, 35 und den Kontaktpads 75, 76 hergestellt werden, mit der Folge, dass sich eine zumindest teilweise Einbettung der Anschlussenden 34, 35 in die Kontaktpads 75, 76 ergibt, wobei diese Einbettung der Anschlussenden 34, 35 in die Kontaktpads 75, 76 auch gleichzeitig mit der Anordnung des Drahtleiters 32 zur Ausbildung der Antenne 33 in Verlegetechnik erfolgen kann.

**Fig. 17** zeigt die nachfolgende Anordnung des Chips 41 im Chipaufnahmebereich 77, wobei Chipanschlüsse 80, 81 benachbart einem Antennenkontaktabschnitt 82 der Kontaktpads 75, 76 in einem Chipkontaktabschnitt 83 der Kontaktpads 75, 76 zur Anlage gegen eine Kontaktseite 89 der Kontaktpads 75, 76 gebracht werden.

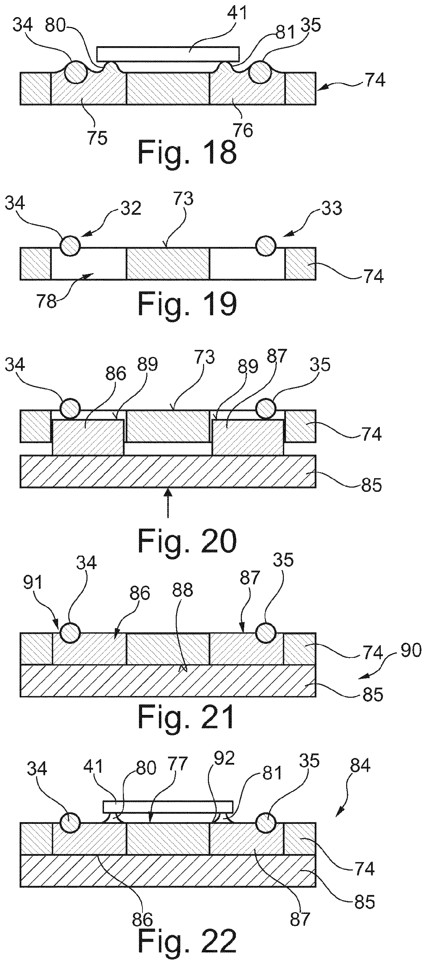

Bei dem in **Fig. 17** dargestellten Ausführungsbeispiel sind die Chipanschlüsse 80, 81 abweichend von dem beispielsweise in den **Fig. 6 und 7** dargestellten Ausführungsbeispiel der Chipanschlüsse 39, 40 nicht als Eindringkörper profiliert ausgebildet, sondern sind als Kontakterhöhungen (bumps) ausgebildet, die eine Verbindung mit den Kontaktpads 75, 76 durch partielles Aufschmelzen ermöglichen, so dass, wie in **Fig. 18** dargestellt, nach dem Aufschmelzen der Chipanschlüsse 80, 81 eine stoffschlüssige Verbindung zwischen den Chipanschlüssen 80, 81 und den Kontaktpads 75, 76 hergestellt ist.

Wie die **Fig. 19 bis 22** zeigen, kann eine gegenüber der in **Fig. 13** dargestellten Transponderlage 72 variierte Transponderlage 84, die in **Fig. 22** gezeigt ist, dadurch hergestellt werden, dass ausgehend von der bereits auf der Antennenseite 73 des Antennensubstrats 74 angeordneten Antenne 33, die Anschlussenden 34, 35 des Drahtleiters 32 aufweist, welche sich über die Substratausnehmungen 78 erstrecken, Kontaktpads 86, 87 in der Substratausnehmung 78 angeordnet werden.

Hierzu wird, wie in **Fig. 20** dargestellt, ein Trägersubstrat 85, auf dem Kontaktpads 86, 87 angeordnet sind, auf einer Unterseite 88 des Antennensubstrats 74 angeordnet und dabei mit den Kontaktpads 86, 87 in die Substratausnehmungen 78 eingeführt, derart, dass den Anschlussenden 34, 35 zugewandte Kontaktseiten 89 der Kontaktpads 86, 87 zur Anlage gegen die Anschlussenden 34, 35 gebracht werden.

Anschließend werden das Antennensubstrat 74 und das Trägersubstrat 85 unter Einwirkung von Druck und Temperatur gegeneinander gepresst, so dass ein Antennenlaminat 90 entsprechend der Darstellung in **Fig. 21** entsteht, wobei die Anschlussenden 34, 35 des Drahtleiters 32 im Bereich von Antennenkontaktabschnitten 91 in die Kontaktpads 86, 87 eingebettet und stoffschlüssig mit ihnen verbunden sind.

**Fig. 22** zeigt schließlich analog der zuvor erörterten Darstellung in **Fig. 18** betreffend die Herstellung der Transponderlage 72 den im Chipaufnahmebereich 77 zwischen den Anschlussenden 34, 35 angeordneten und über seine Chipanschlüsse 80, 81 im Bereich von Chipkontaktabschnitten 92 stoffschlüssig mit den Kontaktpads 86, 87 verbundenen Chip 41.

## Patentansprüche

1. Transponderlage (30, 52) mit einem Antennensubstrat (31), das auf einer Antennenseite (38) mit einer aus einem Drahtleiter (32) gebildeten Antenne (33) und einem Chip (41) versehen ist, und das auf der Antennenseite Anschlussleiter zur Verbindung des Chips mit dem Drahtleiter der Antenne aufweist, derart, dass der Chip neben Anschlussenden (34, 35) des Drahtleiters angeordnet ist, und sowohl die Anschlussenden des Drahtleiters als auch auf einer dem Antennensubstrat zugewandten Kontaktseite (48) eines Halbleiterkörpers (49) des Chips angeordnete Chipanschlüsse (39, 40) mit den Anschlussleitern kontaktiert sind, wobei die Anschlussleiter zur Verbindung des Chips (41) mit dem Drahtleiter (32) der Antenne (33) als Kontaktpads (36, 37; 53, 54) ausgebildet und derart auf der Antennenseite (38) angeordnet sind, dass die Kontaktpads zur Kontaktierung mit der Antenne einen Antennenkontaktabschnitt (42, 57) mit einer der Antennenseite zugewandten Antennenkontaktseite (43, 64) und zur Kontaktierung mit dem Chip einen Chipkontaktabschnitt (45, 58) mit einer der Antennenkontaktseite gegenüberliegenden und von der Antennenseite abgewandten Chipkontaktseite (47, 55) aufweisen,
**dadurch gekennzeichnet,**
**dass** die Kontaktpads (53, 54) mit ihrer Chipkontaktseite (55) auf einem Trägersubstrat (56) angeordnet sind und zur Kontaktierung des Chips (41) mit den Kontaktpads die Chipanschlüsse (39, 40) sich durch das Trägersubstrat hindurch erstrecken.

2. Transponderlage nach Anspruch 1,
**dadurch gekennzeichnet,**
**dass** der Chip (41) zwischen den Anschlussenden (34, 35) des Drahtleiters (32) angeordnet ist.

3. Transponderlage nach Anspruch 1 oder 2,
**dadurch gekennzeichnet,**
**dass** die Kontaktpads (36, 37) zur Kontaktierung mit der Antenne (33) mit ihrer Antennenkontaktseite (43) an den Drahtleiter (32) der Antenne angeschmiegt ausgebildet sind.

4. Laminatinlay für eine aus mehreren Laminatlagen gebildete Laminatstruktur, wobei das Laminatinlay eine Transponderlage nach einem der vorangehenden Ansprüche umfasst,
**dadurch gekennzeichnet,**
**dass** die Transponderlage des Laminatinlays auf ihrer Antennenseite mit einer oberen Decklage versehen ist, die in einem Überdeckungsbereich mit dem Chip auf einer Rückseite des Halbleiterkörpers des Chips angeordnet ist.

5. Laminatinlay nach Anspruch 4,
**dadurch gekennzeichnet,**
**dass** die obere Decklage sowohl auf der Rückseite des Halbleiterkörpers des Chips als auch auf den Kontaktpads angeordnet ist.

6. Laminatinlay nach Anspruch 4,
**dadurch gekennzeichnet,**
**dass** die obere Decklage (69) sowohl auf der Rückseite (65) des Halbleiterkörpers (49) des Chips (41) als auch auf einer Rückseite (66) des Trägersubstrats (56) der Kontaktpads (53, 54) angeordnet ist.

7. Laminatinlay nach Anspruch 4,
**dadurch gekennzeichnet,**
**dass** die obere Decklage sowohl auf der Rückseite des Halbleiterkörpers des Chips als auch auf den Anschlussenden des Drahtleiters der Antenne angeordnet ist.

8. Chipkarte mit einem Laminatinlay nach einem der Ansprüche 4 bis 7.

9. Chipkarte nach Anspruch 8,
**gekennzeichnet durch**
eine unmittelbar auf der oberen Decklage angeordnete obere Außenlage.

10. Chipkarte nach Anspruch 8 oder 9,
**gekennzeichnet durch**
eine auf der Rückseite des Antennensubstrats angeordnete untere Außenlage.

11. Verfahren zur Herstellung einer Transponderlage nach einem der Ansprüche 1 bis 3 mit den Verfahrensschritten:
- Bereitstellung eines Antennensubstrats (31) mit einer auf einer Antennenseite (38) des Antennensubstrats angeordneten, aus einem Drahtleiter (32) gebildeten Antenne (33) mit Anschlussenden (34, 35) des Drahtleiters, die sich mit Abstand voneinander auf der Antennenseite des Antennensubstrats erstrecken;
- Anordnung von Kontaktpads (36, 37; 53, 54) auf den Anschlussenden des Drahtleiters, derart, dass sich die Kontaktpads jeweils mit einem Antennenkontaktabschnitt (42, 57) auf einem Anschlussende und mit einem Chipkontaktabschnitt (45, 58) auf der Antennenseite des Antennensubstrats erstrecken;
- Kontaktierung der Antennenkontaktabschnitte der Kontaktpads mit den Anschlussenden des Drahtleiters;
- Anordnung des Chips (41) in einem neben den Anschlussenden gebildeten Chipaufnahmebereich (46) des Antennensubstrats, derart, dass auf einer Kontaktseite (48) eines Halbleiterkörpers (49) des Chips angeordnete Chipanschlüsse (39, 40) jeweils auf einem Chipkontaktabschnitt der Kontaktpads angeordnet sind;
- Kontaktierung der Chipanschlüsse mit den Chipkontaktabschnitten der Kontaktpads,
**dadurch gekennzeichnet,**
**dass** zur Anordnung der Kontaktpads (53, 54) auf den Anschlussenden (34, 35) des Drahtleiters (32) ein mit den Kontaktpads versehenes Trägersubstrat (56) derart auf der Antennenseite (38) des Antennensubstrats (31) positioniert wird, dass die Antennenkontaktabschnitte (57) der Kontaktpads mit ihrer dem Antennensubstrat zugewandten Antennenkontaktseite (64) zur Anlage gegen die Anschlussenden des Drahtleiters kommen.

12. Verfahren nach Anspruch 11,
**dadurch gekennzeichnet,**
**dass** die Kontaktpads (36, 37; 53, 54) zur Kontaktierung mit den Anschlussenden (34, 35) des Drahtleiters (32) rückwärtig mit Wärme und/oder Druck beaufschlagt werden.

13. Verfahren nach Anspruch 11 oder 12,
**dadurch gekennzeichnet,**
**dass** die rückwärtige Beaufschlagung der Kontaktpads (36, 37; 53, 54) mit Druck mittels eines Ultraschallstempels erfolgt.

## Claims

1. A transponder layer (30, 52) having an antenna substrate (31), which, on an antenna side (38), is equipped with an antenna (33) formed from a wire conductor (32) as well as with a chip (41), and which, on the antenna side, has terminal conductors for connecting the chip to the wire conductor of the antenna in such a manner that the chip is arranged adjacently to terminal ends (34, 35) of the wire conductor, and in such a manner that both the terminal ends of the wire conductor and chip terminals (39, 40), which are arranged on a contact side (48) of a semiconductor body (49) of the chip, the contact side facing towards the antenna substrate, are contacted with the terminal conductors, the terminal conductors for connecting the chip (41) to the wire conductor (32) of the antenna (33) being embodied as contact pads (36, 37; 53, 54) and being arranged on the antenna side (38) in such a manner that the contact pads, for being contacted with the antenna, have an antenna contact portion (42, 57) having an antenna contact side (43, 64) facing towards the antenna side and, for being contacted with the chip, have a chip contact portion (45, 58) having a chip contact side (47, 55) that is opposite to the antenna contact side and faces away from the antenna side,
**characterised in that**
the contact pads (53, 54), with their chip contact side (55), are arranged on a carrier substrate (56) and **in that** the chip terminals (39, 40), for contacting the chip (41) with the contact pads, extend through the carrier substrate.

2. The transponder layer according to claim 1,
**characterised in that**
the chip (41) is arranged between the terminal ends (34, 35) of the wire conductor (32).

3. The transponder layer according to claim 1 or 2,
**characterised in that**
the contact pads (36, 37), for being contacted with the antenna (33), are embodied in such a way as to fit tightly against the wire conductor (32) of the antenna with their antenna contact side (43).

4. A laminate inlay for a laminate structure that is formed from multiple laminate layers, the laminate inlay having a transponder layer according to one of the preceding claims,
**characterised in that**
the transponder layer of the laminate inlay, on its antenna side, is equipped with an upper cover layer, which, in an overlapping region with the chip, is arranged on a rear side of the semiconductor body of the chip.

5. The laminate inlay according to claim 4,
**characterised in that**
the upper cover layer is arranged both on the rear side of the semiconductor body of the chip and on the contact pads.

6. The laminate inlay according to claim 4,
**characterised in that**
the upper cover layer (69) is arranged both on the rear side (65) of the semiconductor body (49) of the chip (41) and on a rear side (66) of the carrier substrate (56) of the contact pads (53, 54).

7. The laminate inlay according to claim 4,
**characterised in that**
the upper cover layer is arranged both on the rear side of the semiconductor body of the chip and on the terminal ends of the wire conductor of the antenna.

8. A chip card having a laminate inlay according to one of the claims 4 to 7.

9. The chip card according to claim 8,
**characterised by**
an upper external layer that is directly arranged on the upper cover layer.

10. The chip card according to claim 8 or 9,
**characterised by**
a lower external layer that is arranged on the rear side of the antenna substrate.

11. A method for producing a transponder layer according to one of the claims 1 to 3, having the method steps:
- providing an antenna substrate (31) having an antenna (33) that is arranged on an antenna side (38) of the antenna substrate and that is formed from a wire conductor (32), having terminal ends (34, 35) of the wire conductor, said terminal ends extending on the antenna side of the antenna substrate at a distance from each other;
- arranging contact pads (36, 37; 53, 54) on the terminal ends of the wire conductor, in such a manner that the contact pads respectively extend on a terminal end with an antenna contact portion (42, 57), and on the antenna side of the antenna substrate with a chip contact portion (45, 58);
- contacting the antenna contact portions of the contact pads with the terminal ends of the wire conductor;
- arranging the chip (41) in a chip accommodating region (46) of the antenna substrate, said chip accommodating region being formed adjacently to the terminal ends, in such a manner that chip terminals (39, 40) that are arranged on a contact side (48) of a semiconductor body (49) of the chip are respectively arranged on a chip contact portion of the contact pads;
- contacting the chip terminals with the chip contact portions of the contact pads.
**characterised in that**
for arranging the contact pads (53, 54) on the terminal ends (34, 35) of the wire conductor (32), a carrier substrate (56) that is equipped with the contact pads is positioned on the antenna side (38) of the antenna substrate (31) in such a manner that the antenna contact portions (57) of the contact pads come to abut against the terminal ends of the wire conductor with their antenna contact side (64) that faces towards the antenna substrate.

12. The method according to claim 11,
**characterised in that**
the contact pads (36, 37; 53, 54), for being contacted with the terminal ends (34, 35) of the wire conductor (32), are treated with heat and/or pressure at the rear.

13. The method according to claim 11 or 12,
**characterised in that**
the contact pads (36, 37; 53, 54) are treated with pressure at the rear by means of an ultrasonic plunger.

## Revendications

1. Couche de transpondeur (30, 52), ayant un substrat d'antenne (31) qui est muni, sur un côté d'antenne (38), d'une antenne (33) formée par un conducteur à fil (32) et d'une puce (41), et qui présente, sur le côté d'antenne, des conducteurs de raccordement pour relier la puce avec le conducteur à fil de l'antenne,
de telle manière que la puce est disposée à côté d'extrémités de raccordement (34, 35) du conducteur à fil, et de telle manière que non seulement les extrémités de raccordement du conducteur à fil, mais aussi des raccordements de puce (39, 40) qui sont disposés sur un côté de contact (48) dirigé vers le substrat d'antenne et appartenant à un corps semi-conducteur (49) de la puce sont contactés avec les conducteurs de raccordement, lesdits conducteurs de raccordement pour relier la puce (41) avec le conducteur à fil (32) de l'antenne (33) étant réalisés comme des pièces de contact (36, 37 ; 53, 54) et étant disposés sur le côté d'antenne (38) de telle manière que les pièces de contact présentent, pour être contactées avec l'antenne, une partie de contact d'antenne (42, 57), ayant un côté de contact d'antenne (43, 64) dirigé vers le côté d'antenne, et pour être contactés avec la puce, une partie de contact de puce (45, 58), ayant un côté de contact de puce (47, 55) en vis-à-vis du côté de contact d'antenne et dirigé à l'opposé du côté d'antenne,
**caractérisée en ce que**
les pièces de contact (53, 54), avec leur côté de contact de puce (55), sont disposées sur un substrat porteur (56) et **en ce que** les raccordements de puce (39, 40) s'étendent à travers le substrat porteur pour contacter la puce (41) avec les pièces de contact.

2. Couche de transpondeur selon la revendication 1,
**caractérisée en ce que**
la puce (41) est disposée entre les extrémités de raccordement (34, 35) du conducteur à fil (32).

3. Couche de transpondeur selon la revendication 1 ou 2,
**caractérisée en ce que**
les pièces de contact (36, 37), pour être contactées avec l'antenne (33), sont réalisées à épouser le conducteur à fil (32) de l'antenne avec leur côté de contact d'antenne (43).

4. Insert stratifié pour une structure stratifiée formée par plusieurs couches stratifiées, ledit insert stratifié comprenant une couche de transpondeur selon l'une quelconque des revendications précédentes,
**caractérisé en ce que**
la couche de transpondeur de l'insert stratifié, sur son côté d'antenne, est munie d'une couche de couverture supérieure qui est disposée, dans une région de recouvrement avec la puce, sur un côté arrière du corps semi-conducteur de la puce.

5. Insert stratifié selon la revendication 4,
**caractérisé en ce que**
la couche de couverture supérieure est disposée non seulement sur le côté arrière du corps semi-conducteur de la puce, mais aussi sur les pièces de contact.

6. Insert stratifié selon la revendication 4,
**caractérisé en ce que**
la couche de couverture (69) supérieure est disposée non seulement sur le côté arrière (65) du corps semi-conducteur (49) de la puce (41), mais aussi sur un côté arrière (66) du substrat porteur (56) des pièces de contact (53, 54).

7. Insert stratifié selon la revendication 4,
**caractérisé en ce que**
la couche de couverture supérieure est disposée non seulement sur le côté arrière du corps semi-conducteur de la puce, mais aussi sur les extrémités de raccordement du conducteur à fil de l'antenne.

8. Carte à puce ayant un insert stratifié selon l'une quelconque des revendications 4 à 7.

9. Carte à puce selon la revendication 8,
**caractérisée par**
une couche extérieure supérieure qui est disposée directement sur la couche de couverture supérieure.

10. Carte à puce selon la revendication 8 ou 9,
**caractérisée par**
une couche extérieure inférieure qui est disposée sur le côté arrière du substrat d'antenne.

11. Procédé pour la fabrication d'une couche de transpondeur selon l'une quelconque des revendications 1 à 3, comprenant les étapes de procédé suivantes :
- la mise à disposition d'un substrat d'antenne (31) ayant une antenne (33) qui est disposée sur un côté d'antenne (38) du substrat d'antenne et qui est formée par un conducteur à fil (32), ayant des extrémités de raccordement (34, 35) du conducteur à fil qui s'étendent sur le côté d'antenne du substrat d'antenne à distance ;
- la disposition de pièces de contact (36, 37 ; 53, 54) sur les extrémités de raccordement du conducteur à fil, de telle manière que chacune des pièces de contact s'étend sur une extrémité de raccordement avec une partie de contact d'antenne (42, 57) et sur le côté d'antenne du substrat d'antenne avec une partie de contact de puce (45, 58) ;
- la mise en contact des parties de contact d'antenne des pièces de contact avec les extrémités de raccordement du conducteur à fil ;
- la disposition de la puce (41) dans une région de logement de la puce (46) du substrat d'antenne formée à côté des extrémités de raccordement, de telle manière que des raccordements de puce (39, 40) qui sont disposés sur un côté de contact (48) d'un corps semi-conducteur (49) de la puce sont disposés sur une partie de contact de puce des pièces de contact chaque fois ;
- la mise en contact des raccordements de puce avec les parties de contact de puce des pièces de contact,
**caractérisé en ce que**
pour disposer les pièces de contact (53, 54) sur les extrémités de raccordement (34, 35) du conducteur à fil (32), un substrat porteur (56) qui est muni des pièces de contact est positionné sur le côté d'antenne (38) du substrat d'antenne (31) de telle manière que les parties de contact d'antenne (57) des pièces de contact viennent en butée contre les extrémités de raccordement du conducteur à fil avec leur côté de contact d'antenne (64) dirigé vers le substrat d'antenne.

12. Procédé selon la revendication 11,
**caractérisé en ce que**
les pièces de contact (36, 37 ; 53, 54) sont alimentées en chaleur et/ou pression de l'arrière pour être contactées avec les extrémités de raccordement (34, 35) du conducteur à fil (32).

13. Procédé selon la revendication 11 ou 12,
**caractérisé en ce que**
l'alimentation en pression des pièces de contact (36, 37 ; 53, 54) de l'arrière est effectuée à l'aide d'une étampe par ultrasons.
